(19) Europäisches Patentamt
European Patent Office
Office européen des brevets

(11) **EP 0 704 946 B1**

(12) **EUROPÄISCHE PATENTSCHRIFT**

(45) Veröffentlichungstag und Bekanntmachung des Hinweises auf die Patenterteilung:
**01.10.2003   Patentblatt 2003/40**

(51) Int Cl.⁷: **H01S 5/10**, G02B 6/12

(21) Anmeldenummer: **95110326.6**

(22) Anmeldetag: **03.07.1995**

(54) **Optoelektronisches Multi-Wellenlängen Bauelement**

Optoelectronic multiwavelength element

Composant opto-électronique multi-longueurs d'onde

(84) Benannte Vertragsstaaten:
**AT BE CH DE DK ES FR GB GR IE IT LI LU MC NL PT SE**

(30) Priorität: **31.08.1994   DE 4432410**

(43) Veröffentlichungstag der Anmeldung:
**03.04.1996   Patentblatt 1996/14**

(73) Patentinhaber: **Deutsche Telekom AG**
**53113 Bonn (DE)**

(72) Erfinder: **Hillmer, Hartmut**
**D-64287 Darmstadt (DE)**

(56) Entgegenhaltungen:
**EP-A- 0 641 053          FR-A- 2 417 866**

- **PATENT ABSTRACTS OF JAPAN vol. 007 no. 136 (E-181) ,14.Juni 1983 & JP-A-58 048981 (KOGYO GIJUTSUIN;OTHERS: 0J) 23.März 1983,**
- **PATENT ABSTRACTS OF JAPAN vol. 011 no. 343 (E-555) ,10.November 1987 & JP-A-62 124791 (MATSUSHITA ELECTRIC IND CO LTD) 6.Juni 1987,**
- **PATENT ABSTRACTS OF JAPAN vol. 016 no. 570 (E-1297) ,10.Dezember 1992 & JP-A-04 221873 (NIPPON TELEGR & TELEPH CORP) 12.August 1992,**
- **PATENT ABSTRACTS OF JAPAN vol. 016 no. 570 (E-1297) ,10.Dezember 1992 & JP-A-04 221872 (NIPPON TELEGR & TELEPH CORP) 12.August 1992,**
- **PATENT ABSTRACTS OF JAPAN vol. 010 no. 104 (E-397) ,19.April 1986 & JP-A-60 242686 (NIPPON DENKI KK) 2.Dezember 1985,**
- **Y.SUEMATSU, A.R.ADAMS 'Handbook of semiconductor lasers and photonic integrated circuits' 1994 , CHAPMAN & HALL , LONDON 214460 * Abschnitte 11.5, 11.7, 15.3 ***
- **IEEE PHOTONICS TECHNOLOGY LETTERS, Bd. 4, Nr. 6, Juni 1992 NEW YORK, US, Seiten 531-534, XP 000275533 K.KUDO ET AL. 'Reduction of effective linewidth enhancement factor of DFB lasers with complex coupling coefficients'**
- **PATENT ABSTRACTS OF JAPAN vol. 011 no. 396 (E-568) ,24.Dezember 1987 & JP-A-62 158377 (SONY CORP) 14.Juli 1987,**
- **IEEE PHOTONICS TECHNOLOGY LETTERS, Bd. 5, Nr. 5, Mai 1993 NEW YORK, US, Seiten 489-491, XP 000368338 V.JAYARAMAN ET AL. 'Extended tuning range in sampled grating DBR lasers'**
- **KADEN C. ET AL: 'Fabrication of nonconventional distributed feedback lasers with variable grating periods and phase shifts by electron beam lithography' JOURNAL OF VACUUM SCIENCE & TECHNOLOGY Bd. 10, Nr. 6, 01 November 1992, NEW YORK, USA, Seiten 2970 - 2973, XP000332508**

Bemerkungen:
Die Akte enthält technische Angaben, die nach dem Eingang der Anmeldung eingereicht wurden und die nicht in dieser Patentschrift enthalten sind.

**Beschreibung**

Die Erfindung findet in photonischen Komponenten Anwendung, welche auf verschiedenen Wellenleiter-Kanälen arbeiten und welche auf DFB (distributed feedback) Gittern, DBR (distributed Bragg reflector) Gittern oder axial mehrfach unterbrochenen Gitterstrukturen (sampled gratings) basieren. Im letzten Fall besteht das Gesamtgitter abwechselnd aus Gitterbereichen und gitterfreien Bereichen, wobei die entsprechenden Längen in axialer Richtung zusätzlich noch variierbar sind. Für folgende photonische Komponenten ist die Erfindung anwendbar: z. B. Laser, Laser-Verstärker, Filter, Koppler, Schalter, Multiplexer, Demultiplexer, Empfänger und Detektoren. Als Beispiel besonders hervorgehoben seien: "laser-amplifier-arrays" und. "laser arrays". "Laser arrays" mit monomodiger Emission auf verschiedenen Wellenlängen sind Schlüsselbauelemente für Frequenzmultiplex Verfahren, beispielsweise in der faseroptischen Nachrichtenübertragung.

Folgende Arbeiten, welche thematisch mit der vorliegenden Erfindung zusammenhängen, sind Stand der Technik:

1. In einem Halbleiterbauelement mit 10 lateral nebeneinander liegenden 3-Sektions DFB Lasern [K. Sato et al., K-2, 13th IEEE Laserkonferenz 1992 in Takamatsu] wurde die Wellenlängenabstimmung über eine aufwendige individuelle Strominjektion in die einzelnen Sektionen der einzelnen Laser realisiert.

2. In der Arbeit von H. Yasaka et al. IEEE Photonics Technol. Lett. 1(4) 75 (1989) wurden Bauelemente vorgestellt, welche simultan auf vier verschiedenen Kanälen arbeiten.

3. Aus der Literatur sind abrupte Änderungen der Korrugationsperiode in longitudinaler Bauelementerichtung bekannt. In der zentral gelegenen Sektion des Laser Resonators wurde holographisch eine größere Korrugationsperiode realisiert als in den Seitensektionen [M. Okai et al., IEEE J. Quantum Electron. 27, 1767 (1991)].

4. In gewissem Rahmen ermöglicht Elektronenstrahl-Lithographie die Variation der Korrugationsperiode von in lateraler Richtung nebeneinander verlaufenden Wellenleitern. Allerdings ist bei diesem Verfahren die Differenz zwischen axial benachbarten Korrugationsperioden auf größere Werte begrenzt. [C. Kaden et al. J. Vac. Sci. Technol. B 10 (6), Nov./Dez. (1992)]. Elektronenstrahl-Lithographie ist ein kompliziertes Verfahren und die Elektronen-Lithographie Schreibzeit ist sehr teuer.

5. Auf DFB Gittern mit konstanter Gitterperiode (homogene DFB Gitter) in der xy-Ebene unterschiedlich gekippt verlaufende Wellenleiter ermöglichen eine Abweichung der Korrugationsperiode im Wellenleiter von derjenigen des ursprünglichen DFB Gitters. Phasenverschiebung [Hirato Shoji, DE 3643361 A1, H 01 S 3/098-C (1987)].

6. Stellvertretend für das thematische Umfeld bezüglich der Erzeugung von Phasenverschiebungen im Wellenleiter sind folgende Arbeiten, die eine abschnittsweise Variation der Dicke oder Breite des Wellenleiters nutzen, ausgeführt:

- Eine laterale Aufweitung oder Verengung der Wellenleiterbreite über eine bestimmte Länge der longitudinalen Bauelemente Richtung wird zur Erzeugung von Phasenverschiebungen genutzt [z. B. H. Soda et al., IEEE J. Quant. Electron. QE-23, 804 (1987), G. Chen et al. Appl. Phys. Lett. 60, 2586 (1992), Y. Nakano et al., IEEE J. Q. Electron. 24, 2017 (1988) oder J. Kinoshita et al. IEEE J. Q. Electron. 27, 1759 (1991)].

- Eine Aufweitung der vertikalen Dicke der aktiven Schicht oder benachbarter Wellenleiterschichten über eine bestimmte Länge der longitudinalen Bauelemente Richtung wird zur Erzeugung von Phasenverschiebungen genutzt [z. B. B. Broberg, et al. Appl. Phys. Lett. 47, 4 (1985) oder K. Kojima et al. J. Ligthwave Technol. LT-3, 1048 (1985)].

7. Gekippte Wellenleiter wurden in Halbleiterlaser-Verstärkern zur Reduktion der Endfacetten Reflektion genutzt [W. I. Way, IEEE Transac. Micr. Techn. 38, 534 (1990)].

8. Gekrümmte Wellenleiter auf homogenen DFB-Gitterfeldern können zur Definition von Gittern mit axial variierter Korrugationsperiode genutzt werden ( siehe DE- PS 42 33 500.0).

9. Von W. T. Tsang et al. IEEE Photon. Technol. Lett. 5, 978 (1993) wurden gekippte Laser-Wellenleiter vorgeschlagen, wobei die Gitterorientierung parallel zur Gittergrenze verläuft. Diese Methode erlaubt eine definierte

EP 0 704 946 B1

Änderung der Bragg-Wellenlänge. Ein Nachteil der vorgeschlagenen Konstellation ist der ungünstige Winkelbereich des Winkels zwischen Wellenleiter und den Gitterstrichen, der nahe bei 90° liegt. Um eine kleine Verschiebung der Bragg-Wellenlänge zu erreichen, muß eine größere, unvorteilhafte Winkeländerung verwendet werden, was zu Einkopplungsproblemen des abgestrahlten Lichtes führt.

10. Aus FR 2 417 866 ist ein Mehrfachlaser mit einem Resonator auf der Basis verteilter Rückkopplung bekannt. Durch verschiedene Winkel zwischen Vorzugsrichtung und der Lichtwellenleiterrichtung wird eine Änderung der charakteristischen Wellenlänge jedes einzelnen Wellenleiters bewirkt. Das Gitter verläuft parallel zur Vorzugsrichtung. Der Winkel zwischen einem Gitterstrich und der Vorzugsrichtung $\varphi$ ist somit gleich 0.

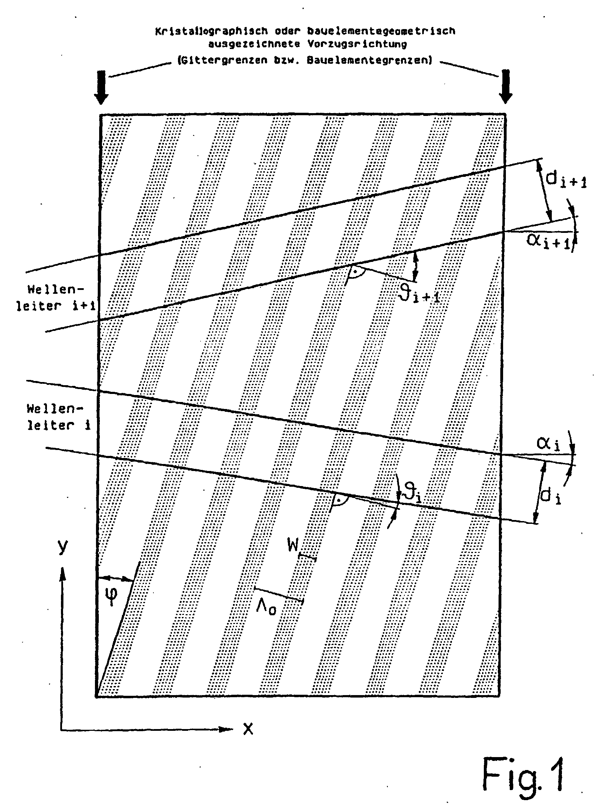

Das Ziel der Erfindung ist es, charakteristische Parameter des photonischen Bauelements so zu verändern, daß sie dem gewünschten Anwendungszweck optimal angepaßt sind.
Die Erfindung wird in den Anspruch 1 und zugehörigen abhängigen Ansprüchen definiert.
Das erfindungsgemäße optoelektronische Bauelement soll es ermöglichen, daß n in der xy-Ebene angeordnete Wellenleiter mit optischen Rückkopplungsgittern, verschiedene charakteristische Wellenlängen aufweisen. Das Koordinatensystem wurde so gewählt, daß die Ebene, in welcher die optischen Achsen der Wellenleiter liegen, mit der xy-Ebene identisch ist. Fig. 1 zeigt das Koordinatensystem und schematisch den Querschnitt von 2 Wellenleitern in der xy-Ebene. Die optische Achse liegt in diesem Beispiel im Zentrum der beiden den Wellenleiter andeutenden Linien. Im allgemeinen Fall können die optischen Achsen in der xy-Ebene gerade oder gekrümmt verlaufen.

Das optoelektronische Multi-Wellenlängen Bauelement besteht aus einer Anzahl n von in der xy-Ebene angeordneten optischen Wellenleitern, welche die Gitterstriche eines oder mehrerer Gitterfelder unter jeweils verschiedenen Winkeln schneiden oder beliebig gekrümmt verlaufen. In den Bereichen der optischen Wellenleiter, in denen die Intensität der geführten Lichtfelder deutlich von Null verschieden ist (die Intensität des Lichtfeldes ist im Gitterbereich größer als 0,1% des Maximums des Lichtfeldes), liegt ein optisches Rückkopplungsgitter, das entweder keine Phasenverschiebungen (Phasensprünge) aufweist und durch eine konstante Korrugationsperiode $\Lambda_o$ gekennzeichnet ist, oder das eine oder mehrere Phasenverschiebungen aufweist und dessen Korrugationsperiode (Gitterperiode) außerhalb eventueller im Gitter enthaltener abrupter Phasenverschiebungen konstant ist. [siehe Ogita et al., IEEE J. Lightwave Technology Vol. 8, 1596 (1990).]
Das DFB-Gitter verläuft zwischen 2 Ebenen, welche parallel zur xy-Ebene angeordnet sind.

Im Fall gekrümmt verlaufender Wellenleiter treten zwischen Gitter und Wellenleiter verschiedene lokale Winkel auf. Ferner ist der Winkel $\varphi$ (siehe Fig. 1) zwischen den Gitterstrichen des Rückkopplungsgitters und einer kristallografisch oder bauelemente-geometrisch ausgezeichneten Richtung (Vorzugsrichtung) von 0° verschieden. Die Winkel $\vartheta_i$, die als Winkel in der xy-Ebene zwischen einer Senkrechten zu einem Gitterstrich und der Richtung des Lichtwellenleiters definiert sind, verlaufen in einem Winkelbereich von -50° bis +50°. Das heißt, daß die Winkel zwischen jedem einzelnen Wellenleiter und den Gitterstrichen der jeweils zugeordneten Gitter im Bereich zwischen 40° und 140° liegen.
Im folgenden wird zunächst der Fall ungekrümmter Wellenleiter betrachtet und danach auf individuell gekrümmte Wellenleiter verallgemeinert.
Durch geeignete Wahl der Zahl der optischen Wellenleiter, wobei grundsätzlich mindestens zwei optische Wellenleiter mit unterschiedlichen Winkeln in der xy-Ebene zwischen einer Senkrechten zu einem Gitterstrich und der Richtung des Lichtwellenleiters $\vartheta_i$ vorhanden sind, und durch geeignete Wahl des lateralen Abstandes der optischen Wellenleiter, der individuellen Wellenleiterbreiten, der Korrugationsperiode $\Lambda_o$ der Gitterbereiche außerhalb der Phasensprünge, des Winkels $\varphi$ zwischen einem Gitterstrich und der Vorzugsrichtung für den Wellenleiter, der axialen Position und der Zahl der Phasenverschiebungen, die im Gitterfeld oder in den Wellenleitern integriert sind, sowie der Längen der Gitterfelder und gitterfreien Bereiche in Wellenleiterrichtung, werden die gewünschten Parameter für das optoelektronische Mutti-Wellenlängen Bauelement festgelegt.
Die vorliegende Lösung ermöglicht die Realisierung von in der xy-Ebene angeordneten Wellenleitern mit optischen Rückkopplungsgittern, welche sich durch unterschiedliche effektive Korrugationsperioden auszeichnen. Das optoelektronische Bauelement basiert auf mehreren optischen Wellenleitern, welche die Gitterstriche eines oder mehrerer Gitterfelder unter jeweils verschiedenen Winkeln $\vartheta_i$ + 90° schneiden. Dabei verlaufen die im optoelektronischen Bauelement angeordneten Gitterstriche des Rückkopplungsgitters/der Rückkopplungsgitter gegenüber einer Vorzugsrichtung um den Winkel $\varphi$ verkippt. Die Winkel $\vartheta_i$ zwischen jedem einzelnen Wellenleiter und der Senkrechten zu einem Gitterstrich des zugeordneten Gitters verlaufen in einem Winkelbereich von -50° bis +50°. Das heißt, daß die Winkel zwischen jedem einzelnen Wellenleiter und den Gitterstrichen der jeweils zugeordneten Gitter im Bereich zwischen 40° und 140° liegen.
Auf dem Bauelement sind mindestens zwei optische Wellenleiter mit unterschiedlichen Winkeln $\vartheta_i$ angeordnet, wobei eine gezielte Änderung der effektiven Korrugationsperiode von Wellenleiter zu Wellenleiter durch die für jeden Wellenleiter individuelle Bemessung des Winkels $\vartheta_i$ des ihm zugeordneten Rückkopplungsgitters erfolgt. Die für die er-

3

wünschte Wellenlänge $\lambda_{B,i}$ erforderlichen Winkel $\vartheta_i$ werden dabei für ein Gitter erster Ordnung nach der Beziehung

$$\vartheta i = \arccos \left(\frac{\Lambda_o \cdot 2 \cdot n_{eff,i}}{\lambda_{B,i}}\right)$$

festgelegt.

Die erfindungsgemäße Lösung wird anhand von mehreren Ausführungsbeispielen und Beispielen, welche das Verständnis der Erfindung erleichtern (insbesondere für die nachfolgenden Rechenbeispiele), näher erläutert.

In Figur 1 ist das Schema eines Ausschnitts des optischen Rückkopplungsgitters dargestellt, welches zwei unterschiedlich gekippte optische Wellenleiterkerne enthält, die in vertikaler Richtung (senkrecht zur xy-Ebene) oberhalb oder unterhalb bzw. innerhalb des dargestellten homogenen Gitterfeldes verlaufen. Damit kann das optoelektronische Bauelement simultan auf zwei verschiedenen Frequenz-Kanälen arbeiten. Die Wellenlängen-Abstände der einzelnen Wellenleiter zueinander sind durch die Winkel $\vartheta_i$ mit äußerst hoher Präzision kontrollierbar und einstellbar. Dabei ist $\Lambda_o$ die Korrugationsperiode der Gitterbereiche außerhalb der eventuell im Gitter enthaltenen Phasenverschiebungen (Phasensprünge), W die Gitterstegbreite und $W/\Lambda_o$ das Tastverhältnis. Ferner ist $\vartheta_i$ der Winkel in der xy-Ebene zwischen einer Senkrechten zu einem Gitterstrich und der Richtung des Lichtwellenleiters i. Der Winkel $\alpha_i$ beschreibt den Ein- oder Austrittswinkel des Wellenleiters i. Die Breite der Wellenleiter kann verschieden sein (hier $d_i$ und $d_{i+1}$), was sich auf den effektiven Brechungsindex $n_{eff,i}$ des Wellenleiters i auswirkt. Die dargestellten linken und rechten Gittergrenzen stehen für kristallographisch oder bauelemente-geometrisch ausgezeichnete Richtungen (Vorzugsrichtungen). Es kann sich bei den Vorzugsrichtungen um gespaltene oder geätzte Gittergrenzen, gespaltene oder geätzte Bauelementegrenzen, gespaltene Halbleiterwafer-Grenzen oder geätzte Grenzen auf dem Halbleiterwafer handeln. Die effektive Korrugationsperiode $\Lambda(\vartheta_i)$ der Gitterbereiche außerhalb der Phasenverschiebungen (Phasensprünge) ist über den Winkel $\vartheta_i$ folgendermaßen einstellbar:

$$\Lambda(\vartheta_i) = \Lambda_o / \cos(\vartheta_i).$$

Die charakteristische Bragg-Wellenlänge eines einzelnen Wellenleiters i ist dann gegeben durch

$$\lambda_{B,i}(\vartheta_i) = 2\, n_{eff,i}\, \Lambda(\vartheta_i).$$

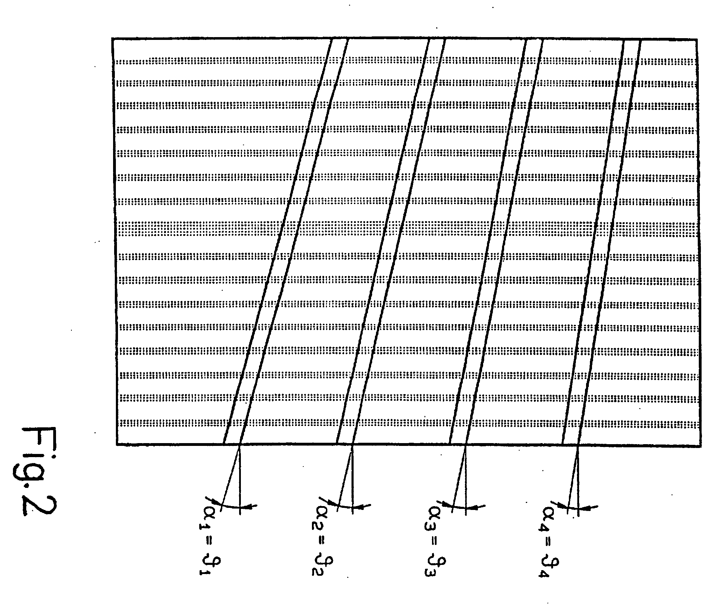

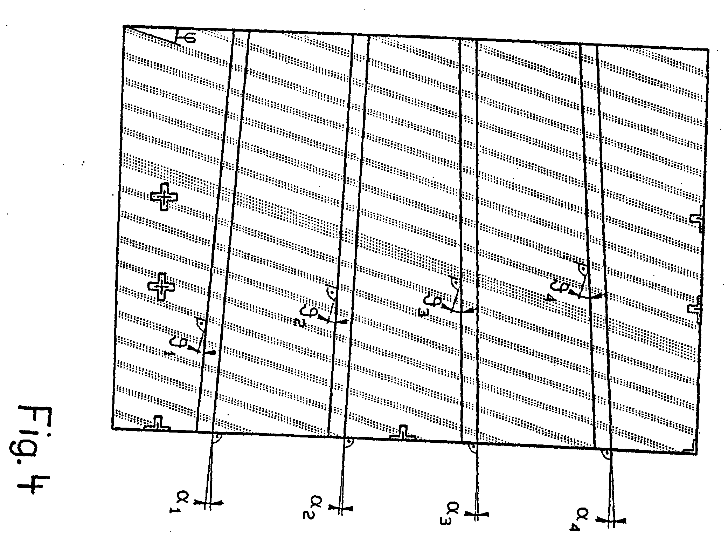

Die Abstufung der effektiven Korrugationsperiode von Wellenleiter zu Wellenleiter wird z. B. mittels verschieden gekippt verlaufender optischer Lichtwellenleiter realisiert, welche im Bereich von optischen Rückkopplungs-Gittern liegen. Die Gitter können entweder keine oder eine bestimmte Anzahl k von Phasenverschiebungen $\Delta\psi_l$ ($l \leq 1 \leq k$) beinhalten. In Figur 1 ist k = 0, in den Figuren 2 und 4 ist k = 1 gewählt. Die Erzeugung der in Wellenleiterrichtung variierbaren, effektiven Korrugationsperiode resultiert aus der gezielten, individuellen Kippung der optischen Wellenleiter relativ zu den Gitterstrichen, d. h., die optischen Wellenleiter schneiden die Gitterstriche nicht in jedem Wellenleiter i unter demselben Winkel. Durch die gezielte Verkippung des Wellenleiters i treten je nach Winkel $\vartheta_i$ um den Faktor $1/\cos(\vartheta_i)$ gegenüber ihrer ursprünglichen Länge verschieden gedehnte Gitterstege $W_i$ oder Gittergräben $[\Lambda_i - W_i]$ auf.

Zur Verdeutlichung sind jedoch in den Abbildungen die Bauelemente-Ausdehnungen, die Winkel, die Wellenleiterbreiten und die Korrugationsperioden nicht maßstabsgerecht dargestellt. Typischerweise ist $d_i \gg \Lambda_o$. Zur Erzeugung von typischen Änderungen der Korrugationsperiode zwischen benachbarten Wellenleitern sind nur sehr moderate Kippungswinkel erforderlich. Die Darstellungen in den Figuren übertreiben die Verkippung zur Verdeutlichung.

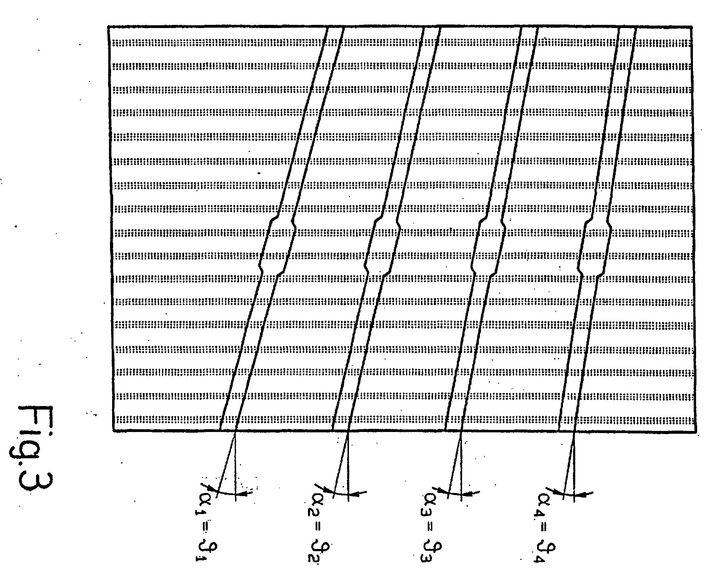

Bei den Figuren 2 und 3 handelt es sich um Beispiele die das Verständnis der Erfindung erleichtern.

Das Gesamt-Gitterfeld wird z. B. holographisch hergestellt, mit Elektronenstrahl-Lithografie definiert oder mit Ionenstrahl-Lithographie realisiert. Das Gitter kann auch DBR-artig sein oder eine Übergitterstruktur ("sampled grating") aufweisen, wobei in Wellenleiterrichtung zusätzlich eine bestimmte Anzahl gitterfreier Bereiche existieren. Das Gitter kann z. B. rein reelle Indexkopplung bewirken, rein imaginäre Indexkopplung oder komplexe Kopplung (reelle und imaginäre Kopplung). Die Querschnitts-Form des Gitters kann z. B. dreieckförmig, rechteckförmig oder sinusartig verlaufen. Ferner sind entsprechende Mischformen möglich, wie z. B. eine Rechteckform mit abgerundeten Ecken.

Figur 2 zeigt die Aufsicht mit einer abrupten Phasenverschiebung (lokal verbreiterter Gittersteg). In diesem Beispiel verlaufen die Gitterstege parallel zum linken Rand des Gitterfeldes, welcher eine kristallographische oder bauelemente-geometrische Vorzugsrichtung darstellt. In diesem Beispiel ist der Einund Austrittswinkel $\alpha_i$ des Wellenleiters i identisch mit dem Winkel $\vartheta_i$, welcher von einer Senkrechten auf einen Gitterstrich und dem Wellenleiter gebildet wird. Der Betrag der Phasenverschiebung wird in diesem Beispiel im Gitter erzeugt und ist in allen vier dargestellten Wellenleitern identisch. Das heißt, der im Gitter eingestellte Phasenverschiebungsbetrag bleibt auch für verschiedene Wellenleiterkippungen erhalten. Zur Verdeutlichung wurde die Korrugationsperiode $\Lambda_o$ der Gitterbereiche außerhalb der Phasensprünge und die laterale Breite des Wellenleiters i, $d_i$ in derselben Größenordnung gewählt. Typischerweise ist jedoch $d_i \gg \Lambda_o$.

Figur 3 zeigt ein nicht phasenverschobenes DFB Gitterfeld mit einer Figur 2 entsprechenden Winkel- und Wellenleiterkonfiguration. Die Phasenverschiebung wird in diesem Fall in den Wellenleitern durch eine über eine definierte Teillänge des Wellenleiters erweiterte Breite realisiert (lokale, abschnittsweise Wellenleiterverbreiterung). Der Betrag der Phasenverschiebung ist in allen vier dargestellten Wellenleitern identisch und unabhängig vom Betrag der Wellenleiterkippung.

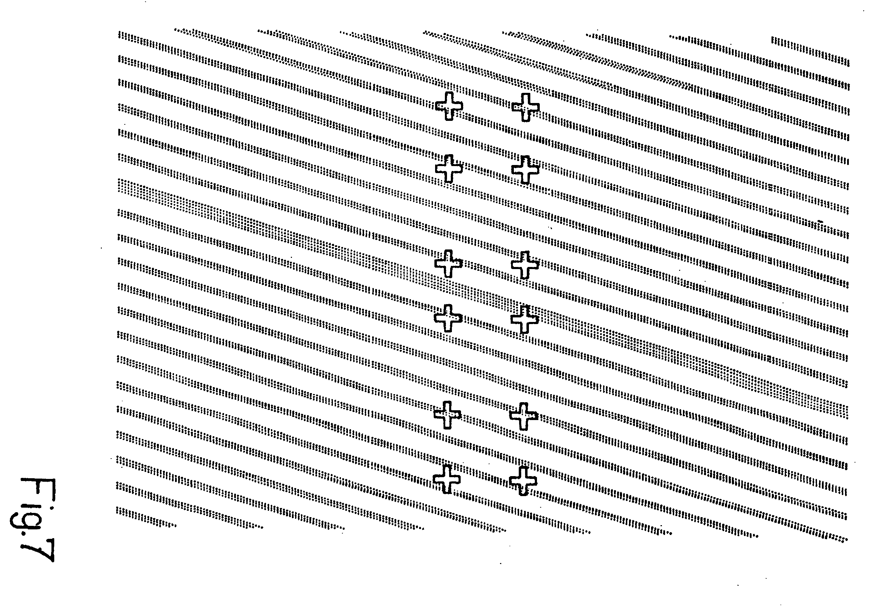

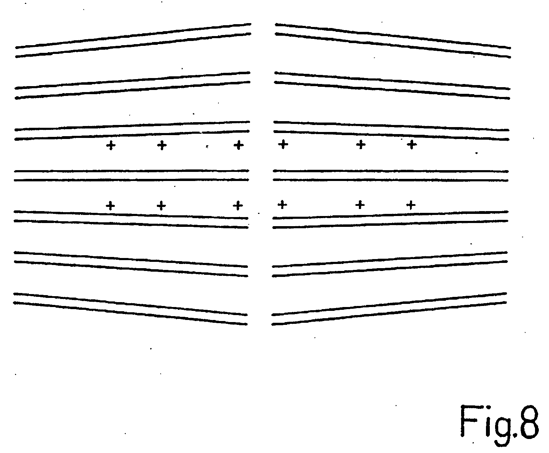

Figur 4 zeigt ein phasenverschobenes DFB-Gitterfeld, welches gegenüber der linken Gitterbegrenzung um den Winkel zwischen einem Gitterstrich und der Vorzugsrichtung $\varphi$ verkippt ist. Die Bedeutung der Justierkreuze wird in Figur 7 und 8 an einem Beispiel erläutert. Ein Vorteil dieser symmetrischen Anordnung der Ein- oder Austrittswinkel des Lichtwellenleiters [$\alpha_1 = -\alpha_4$ und $\alpha_2 = -\alpha_3$] ist der kleinere Winkelunterschied $\Delta\alpha_i$ in der Kippung benachbarter Wellenleiter, wenn z. B. ein bestimmter Wellenlängen-Abstand von Wellenleiter zu Wellenleiter vorgegeben ist. Ein weiterer Vorteil der in Figur 4 gezeigten Anordnung ($\varphi > 0$) gegenüber den in den Figuren 2 und 3 gezeigten Beispielen ist, daß die Ein- oder Austrittswinkel des Lichtwellenleiters i, $\alpha_i$ wesentlich kleiner gewählt werden können, wenn eine bestimmte Wellenlängen-Verschiebung von Wellenleiter zu Wellenleiter vorgegeben wird. Ein eventueller Nachteil dieses Beispiels ist die lokale Verschiebung des Ortes der Phasenverschiebung in x-Richtung von Wellenleiter zu Wellenleiter.

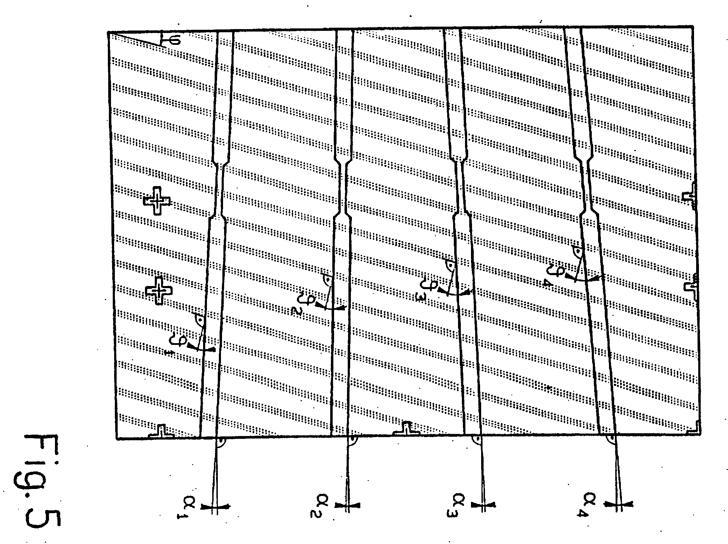

Figur 5 zeigt ein nicht phasenverschobenes DFB Gitter, welches gegenüber der linken Gittergrenze um den Winkel zwischen einem Gitterstrich und der Vorzugsrichtung $\varphi$ verkippt ist. Die dargestellte Winkel- und Wellenleiterkonfiguration entspricht der in Figur 4 gezeigten Wellenleiterkonfiguration. Da die Phasenverschiebung in allen 4 dargestellten Wellenleitern durch eine über eine definierte Teillänge des Wellenleiters reduzierte Breite realisiert wird (lokale, abschnittsweise Wellenleiterverengung), ist der Ort der Phasenverschiebung in x-Richtung präzise einstellbar. Der Nachteil, der mit der in Figur 4 beschriebenen Lösung verbunden ist, kann wie in Figur 5 gezeigt, umgangen werden.

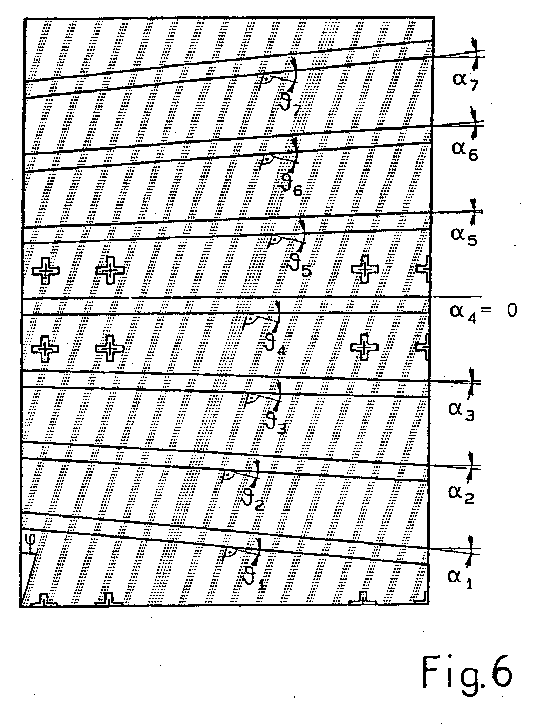

Figur 6 zeigt ein phasenverschobenes DFB Gitterfeld, welches gegenüber der linken Gittergrenze um den Winkel $\varphi$ verkippt ist. Ein Vorteil dieser symmetrischen Anordnung der Ein- oder Austrittswinkel der Lichtwellenleiter [$\alpha_1 = -\alpha_7$, $\alpha_2 = -\alpha_6$ und $\alpha_3 = -\alpha_5$] ist auch hier der extrem kleine Winkelunterschied $\Delta\alpha_i$ in der Kippung benachbarter Wellenleiter. Eine Besonderheit dieses Beispiels ist, daß der mittlere Wellenleiter senkrecht zu der linken und rechten Gitterbegrenzung verläuft, d. h. $\alpha_4 = 0$. Für die Festlegung des Ein- oder Austrittswinkels $\alpha_i$ des Lichtwellenleiters i, des Winkels $\vartheta_i$ und des Winkels zwischen einem Gitterstrich und der Vorzugsrichtung $\varphi$ sind die Justiermarken (Justierkreuze) angedeutet, welche in den Figuren 2 - 6 enthalten sind. In den folgenden 2 Abbildungen wird ein Beipiel für die Verwendung der Justiermarken erläutert. Die Justierkreuze können bei identischem, exakt kontrollierbarem Bezug aller Prozeßschritte auf eine Vorzugsrichtung des Bauelements entfallen.

Figur 7 zeigt das Beispiel eines mit Elektronenstrahl-Lithographie geschriebenen DFB-Gitter inklusive der definierten Justierkreuze, welche relativ zu einer definierten Vorzugsrichtung ausgerichtet werden, wie in den Beispielen 4 - 6 gezeigt ist. Dieses Vorgehen definiert den Winkel zwischen einem Gitterstrich und der Vorzugsrichtung $\varphi$. Für die Herstellung der Wellenleiter kann z. B. eine Maske, wie in Figur 8 dargestellt, verwendet werden, welche auch geeignete komplementäre Markierungskreuze (Justiermarken) beinhaltet, die bei korrektem Übereinanderjustieren der korrespondierenden Kreuze die Ein- oder Austrittswinkel $\alpha_i$ des Lichtwellenleiters i, und die Winkel $\vartheta_i$ festlegen. Beim Übereinanderlegen der Figuren 7 und 8 ergibt sich nach dem Justieren der korrespondierenden Kreuze eine Anordnung, welche ausschnittsweise der Anordnung nach Figur 6 ähnlich ist.

Die Verwendung von Justierkreuzen für die Definition des Winkels zwischen einem Gitterstrich und der Vorzugsrichtung $\varphi$ ist jedoch nicht zwingend. Bei der holographischen Gitterherstellung kann der Winkel zwischen einem Gitterstrich und der Vorzugsrichtung $\varphi$ auch direkt durch präzise Drehung des Halbleiterwafers vor der Belichtung eingestellt werden. Für die nachfolgende Wellenleiterherstellung, z. B. mittels Photomasken, ist jedoch die Verwendung von Justiermarken anzuraten. Diese Justiermarken werden dann z. B. bezüglich einer kristallographisch oder bauelemente-geometrisch ausgezeichneten Richtung ausgerichtet.

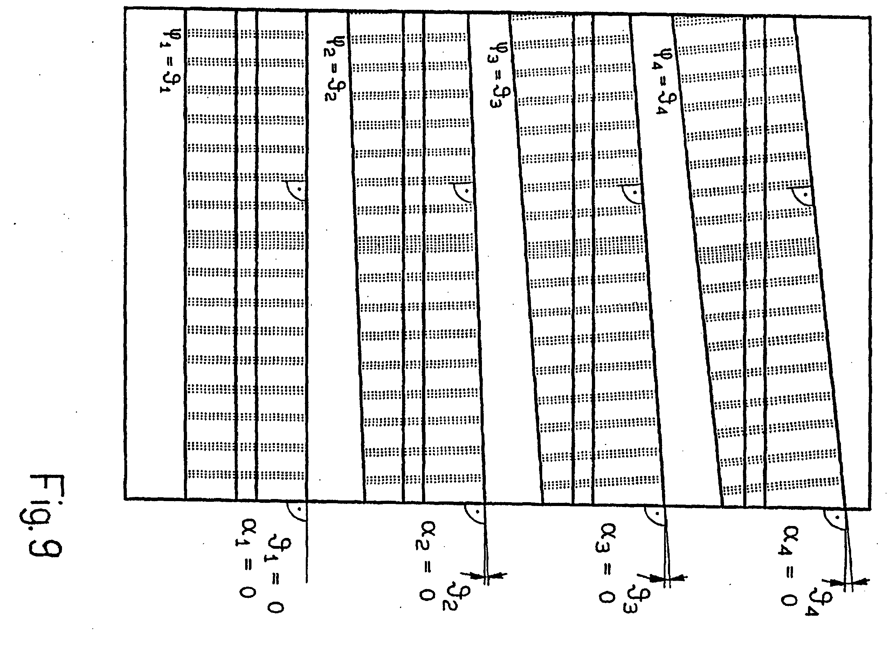

Figur 9 zeigt eine Teilansicht eines Bauelements mit 4 Wellenleitern. Der Vorteil dieser Lösung ist, daß alle Einoder Austrittswinkel des Lichtwellenleiters i = Null sind, d. h., daß alle Wellenleiter die linke und rechte Gitterbegrenzung (z. B. im Falle eines DFB- Hableiterlasers die zwei Resonator-Endflächen) senkrecht schneiden. Jedoch liegt dieser Lösung kein einheitliches Gitterfeld zugrunde, sondern bei i Wellenleitern maximal i individuelle Gitterfelder, welche alle in unterschiedlicher Art und Weise gegenüber den zugehörigen Wellenleitern i verkippt sein können. Ein weiterer Vorteil dieser Lösung ist, daß die im Gitter integrierte Phasenverschiebung an derselben Stelle in x-Richtung im Wellenleiter untergebracht werden kann. Auch in diesem Beispiel lassen sich die einzelnen Gitterfelder mit der kostengünstigeren holographischen Methode realisieren. Jedes Gitterfeld i kann dabei streifenförmig, wie in Figur 9 gezeigt, hergestellt werden, wobei zuvor der Winkel $\varphi$ zwischen einem Gitterstrich und der Vorzugsrichtung direkt durch präzises Drehen des Halbleiterwafers eingestellt wurde.

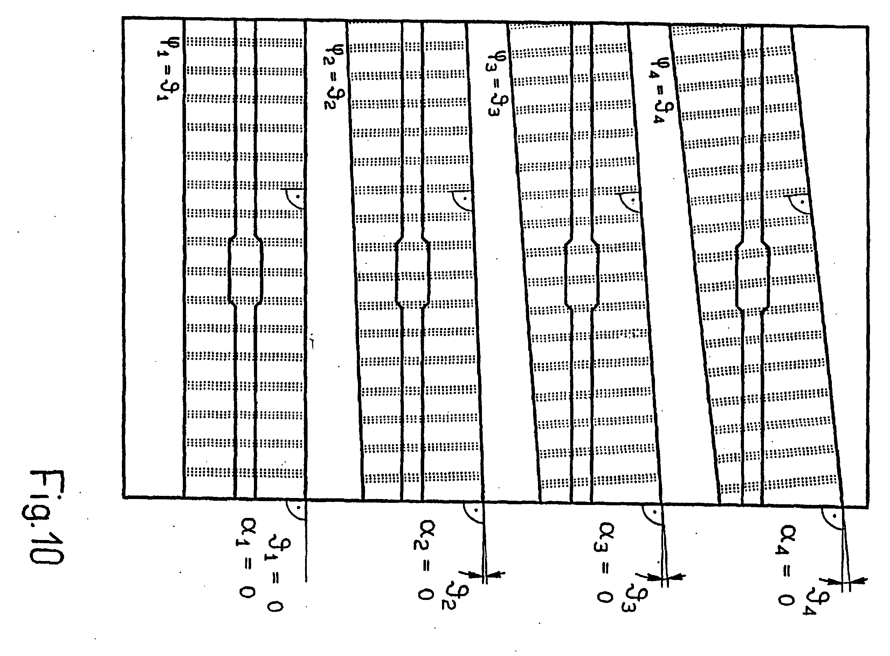

Figur 10 zeigt die zu Figur 9 korrespondierende Lösung, bei der die Phasenverschiebung in jedem Wellenleiter durch eine lokale, abschnittsweise Vergrößerung der Wellenleiterbreite definiert wird.

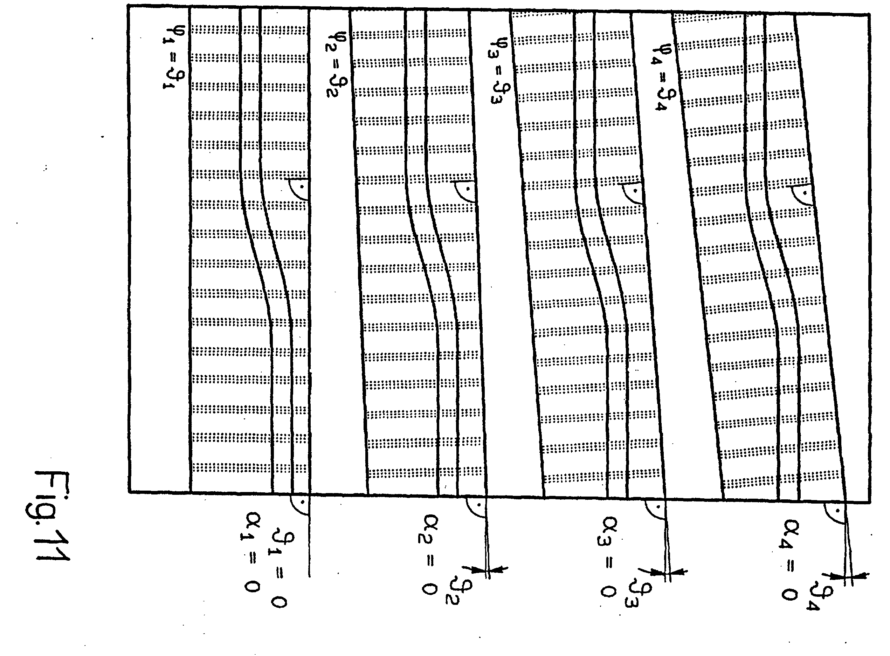

Figur 11 zeigt die zu Figur 9 und 10 korrespondierende Lösung, bei der die Phasenverschiebung in jedem Wellenleiter durch eine abschnittsweise Krümmung des Wellenleiters definiert wird. Diese Lösung erlaubt eine effiziente räumliche Verteilung der Phasenverschiebung. Die Lösungen, welche in den Figuren 9 - 11 dargestellt sind, garantieren gleiche Längen aller Wellenleiter, wenn die linken und rechten Gitterbegrenzungen parallel zueinander gewählt werden, wie z. B. beim kristallographischen Spalten.

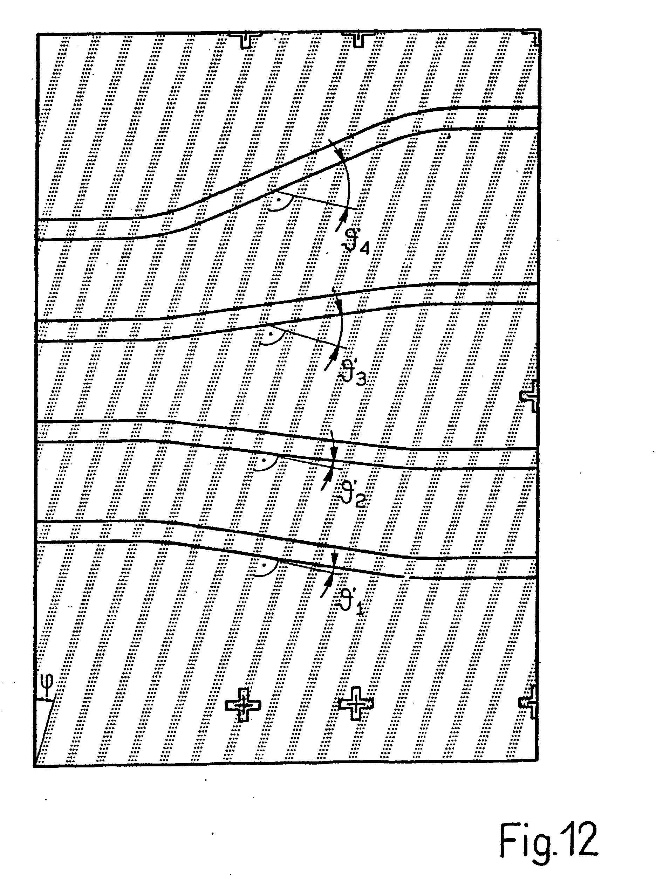

Figur 12 zeigt ein nicht phasenverschobenes DFB-Gitter, welches gegenüber der linken Gittergrenze um den Winkel zwischen einem Gitterstrich und der Vorzugsrichtung φ verkippt ist. Die Phasenverschiebung wird in jedem Wellenleiter durch eine individuelle Wellenleiterkrümmung realisiert. Im dargestellten Beispiel ist jeder Wellenleiter aus drei geraden und zwei gekrümmten Teilstücken aufgebaut.

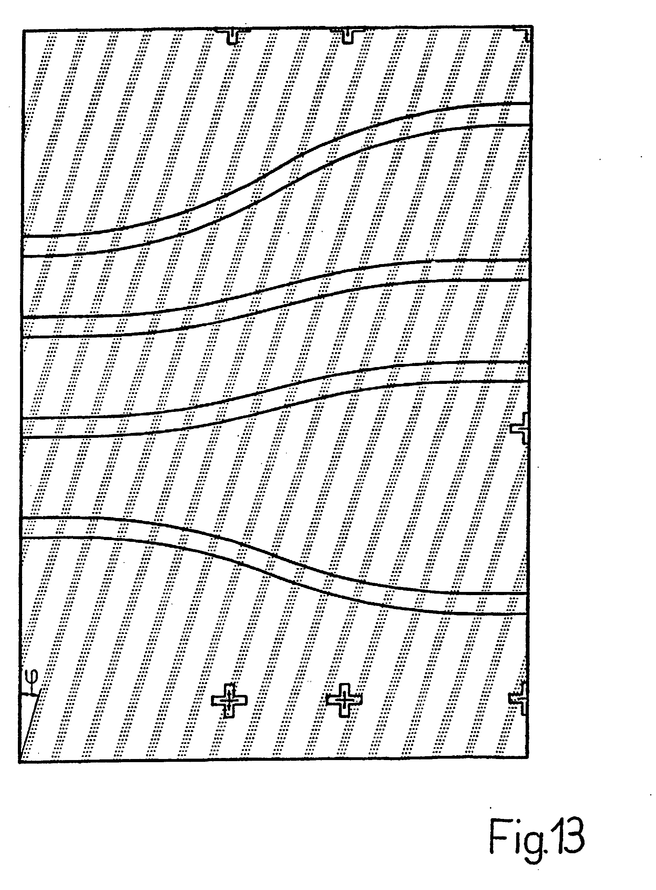

Figur 13 zeigt ein nicht phasenverschobenes DFB-Gitter, welches gegenüber der linken Gittergrenze um den Winkel φ verkippt ist. Die Phasenverschiebung wird in jedem Wellenleiter durch eine individuelle Wellenleiterlösung realisiert und ist hierbei über die gesamte Gitterlänge verteilt.

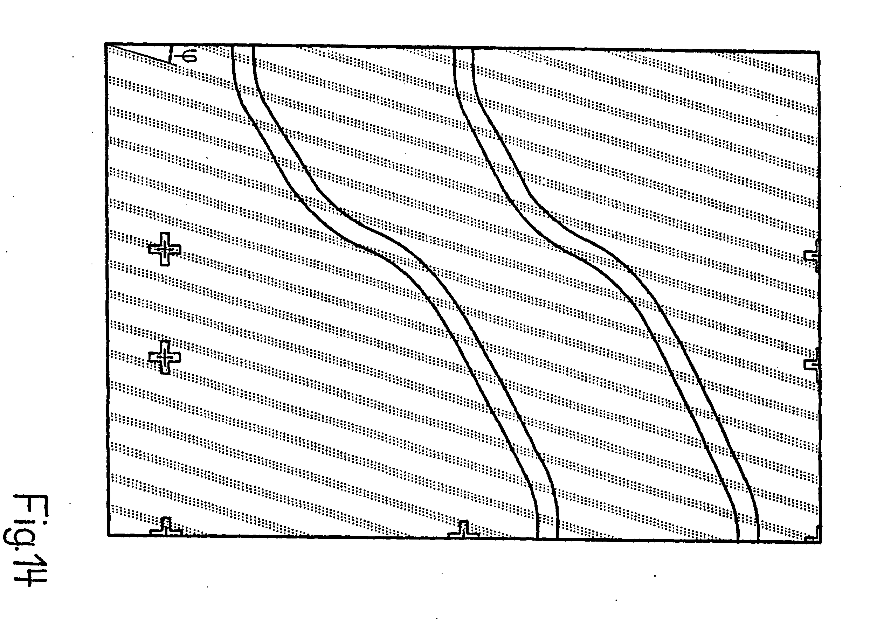

Figur 14 zeigt ein nicht phasenverschobenes DFB-Gitter, welches gegenüber der linken Gittergrenze um den Winkel zwischen einem Gitterstrich und der Vorzugsrichtung φ verkippt ist. Die Phasenverschiebung wird in jedem Wellenleiter durch eine individuelle Wellenleiterkrümmung realisiert. Im dargestellten Beispiel ist jeder Wellenleiter aus drei geraden und vier gekrümmten Teilstücken aufgebaut.

Um eine Wellenlängen-Differenz im Bereich weniger Nanometer zu erzeugen, liegen die Differenz-Winkel [$\vartheta_i - \vartheta_{i+1} = \Delta\vartheta_{i,i+1}$] bei optimiertem Design und φ ungleich 0 typischerweise in der Größenordnung von 1°. Da sehr kleine Winkel ausreichen zur Erzeugung kleiner Wellenlängen-Differenzen benachbarter Wellenleiter, liegen die auftretenden Winkel $\vartheta_i$ und die Ein- oder Austrittswinkel $\alpha_i$ eines Lichtwellenleiters i typischerweise zwischen 0° und 20°. Die erfindungsgemäße Lösung soll anhand einiger Rechenbeispiele näher erläutert werden. Dabei ist $\Delta\vartheta_{i,i} + 1$ bzw. $\Delta\alpha_{i,i} + 1$ die WinkelDifferenz benachbarter Wellenleiter.

Für die Rechenbeispiele werden für alle Wellenleiter die gleiche Wellenleiterbreite und der gleiche effektive Brechungsindex $n_{eff} = 3.2700422$ angenommen. Anvisiert wird jeweils eine bestimmte Wellenlängendifferenz $\Delta\lambda$ zwischen benachbarten Wellenleitern.

$$\text{1. Rechenbeispiel:} \quad \Delta\lambda = 1nm, \quad \Lambda_O = 237nm, \quad \vartheta_1 = 0°$$

$$\lambda_1 = 1.550\mu m \quad \Lambda_1 = 237,000nm \quad \vartheta_1 = 0.00000°$$

$$\Delta\vartheta_{12} = 2.060°$$

$$\lambda_2 = 1.551\mu m \quad \Lambda_2 = 237.153nm \quad \vartheta_2 = 2.05755°$$

$$\Delta\vartheta_{23} = 0.815°$$

$$\lambda_3 = 1.552\mu m \quad \Lambda_3 = 237.306nm \quad \vartheta_3 = 2.90900°$$

$$\Delta\vartheta_{34} = 0.653°$$

$$\lambda_4 = 1.553\mu m \quad \Lambda_4 = 237.459nm \quad \vartheta_4 = 3.56190°$$

Hierbei sind die Winkel $\alpha_i = \vartheta_i$. Ferner ist $\Delta\vartheta_{12}$ ungewöhnlich groß. Dieser Nachteil wird in den folgenden Beispielen vermieden.

2. Rechenbeispiel: $\Delta\lambda = 1nm$, $\Lambda_O = 236.6752nm$, $\vartheta_1 = 3°$

$\lambda_1 = 1.550\mu m$   $\Lambda_1 = 237.0000nm$   $\vartheta_1 = 3.0000 °$

$\Delta\vartheta_{12} = 0.64 °$

$\lambda_2 = 1.551\mu m$   $\Lambda_2 = 237.1529nm$   $\vartheta_2 = 3.6373 °$

$\Delta\vartheta_{23} = 0.54 °$

$\lambda_3 = 1.552\mu m$   $\Lambda_3 = 237.3058nm$   $\vartheta_3 = 4.1780 °$

$\Delta\vartheta_{34} = 0,48 °$

$\lambda_4 = 1.553\mu m$   $\Lambda_4 = 237.4587nm$   $\vartheta_4 = 4.6560 °$

Dieses Beispiel korrespondiert zu Figur 2 und 3. Die Winkeldifferenz $\Delta\vartheta_{i,i+1}$ ist hierbei wesentlich homogener und vorteilhafter verteilt.

3. Rechenbeispiel: $\Delta\lambda = 1nm$, $\Lambda_O = 235.7017nm$, $\vartheta_1 = 6 °$

$\lambda_1 = 1.550\mu m$   $\Lambda_1 = 237.0000nm$   $\vartheta_1 = 6.000 °$

$\Delta\vartheta_{12} = 0.34 °$

$\lambda_2 = 1.551\mu m$   $\Lambda_2 = 237.1529nm$   $\vartheta_2 = 6.342 °$

$\Delta\vartheta_{23} = 0.32 °$

$\lambda_3 = 1.552\mu m$   $\Lambda_3 = 237.3058nm$   $\vartheta_3 = 6.666 °$

$\Delta\vartheta_{34} = 0.31 °$

$\lambda_4 = 1.553\mu m$   $\Lambda_4 = 237.4587nm$   $\vartheta_4 = 6.974 °$

Dieses Beispiel korrespondiert ebenfalls zu Figur 2 und 3. Durch Vergrößerung des Anfangswinkels $\vartheta_1$ (hier 6 ° gegenüber 3 ° in Beispiel 2) verkleinert die Winkeldifferenzen $\Delta\vartheta_{i,i+1}$ wesentlich.

4. Rechenbeispiel: $\Delta\lambda = 4nm$, $\Lambda_O = 234.6935nm$, $\vartheta_1 = 8 °$

$\lambda_1 = 1.550\mu m$   $\Lambda_1 = 237.0000nm$   $\vartheta_1 = 8.000 °$

$\Delta\vartheta_{12} = 0.989 °$

$\lambda_2 = 1.554\mu m$   $\Lambda_2 = 237.6116nm$   $\vartheta_2 = 8.989 °$

$\Delta\vartheta_{23} = 0.886 °$

$\lambda_3 = 1.558\mu m$   $\Lambda_3 = 238.2232nm$   $\vartheta_3 = 9.875 °$

$\Delta\vartheta_{34} = 0.810 °$

$\lambda_4 = 1.562\mu m$   $\Lambda_4 = 238.8348nm$   $\vartheta_4 = 10.685 °$

Dieses Beispiel korrespondiert ebenfalls zu Figur 2 und 3 und zeigt, daß sogar große Wellenlängendifferenzen $\Delta\vartheta_{i,i+1}$ realisiert werden können.

5. Rechenbeispiel: $\Delta\lambda = 4nm$, $\Lambda_O = 234.6935nm$, $\vartheta = 8°=\varphi$

$\lambda_1=1.550\mu m$   $\Lambda_1=237.0000nm$   $\vartheta_1= 8.000°$   $\alpha_1=0.00°$

$\Delta\alpha_{12}=0,99°$

$\lambda_2=1.554\mu m$   $\Lambda_2=237.6116nm$   $\vartheta_2= 8.989°$   $\alpha_2=0.99°$

$\Delta\alpha_{23}=0,89°$

$\lambda_3=1.558\mu m$   $\Lambda_3=238.2232nm$   $\vartheta_3= 9.875°$   $\alpha_3=1.88°$

$\Delta\alpha_{34}=0.81°$

$\lambda_4=1.562\mu m$   $\Lambda_4=238.8348nm$   $\vartheta_4=10,685°$   $\alpha_4=2.69°$

Dieses Beispiel korrespondiert zu Figur 4 und 5, insofern als das Gitter gegenüber der Gittergrenze um den Winkel $\varphi$ gekippt wurde. Hier wird die Realisierung kleiner $\alpha_i$ demonstriert.

6. Rechenbeispiel: $\Delta\lambda = 4nm$, $\Lambda_O = 234.6935nm$,

$\varphi=(\vartheta_2 + \vartheta_3) \cdot 0,5$

$\lambda_1=1.550\mu m$   $\Lambda_1=237.0000nm$   $\vartheta_1= 8.000°$   $\alpha_1=+1.435°$

$\Delta\alpha_{12}=0.995°$

$\lambda_2=1.554\mu m$   $\Lambda_2=237.6116nm$   $\vartheta_2= 8.989°$   $\alpha_2=+0.44°$

$\Delta\alpha_{23}=0.880°$

$\lambda_3=1.558\mu m$   $\Lambda_3=238.2232nm$   $\vartheta_3= 9.875°$   $\alpha_3=-0.44°$

$\Delta\alpha_{34}=0.990°$

$\lambda_4=1.562\mu m$   $\Lambda_4=238.8348nm$   $\vartheta_4=10,685°$   $\alpha_4=-1.435°$

Dieses Beispiel korrespondiert zu Figur 4 und 5. Es werden sehr kleine Winkel $\varphi_i$ realisiert durch symmetrische Verkippung der Wellenleiter ($\alpha_2 = -\alpha_3$, $\alpha_1 = -\alpha_4$).

7. Rechenbeispiel: $\Delta\lambda = 4nm$, $\Lambda_O = 237nm$

$\lambda_1= 1.550\mu m$   $\Lambda_1= 237.0000nm$   $\vartheta_1= 0,0000°$

$\Delta\alpha_{12} = 0°$

$\lambda_2= 1.554\mu m$   $\Lambda_2= 237.6116nm$   $\vartheta_2= 4.1118°$

$\Delta\alpha_{23} = 0°$

$\lambda_3= 1.558\mu m$   $\Lambda_3= 238.2232nm$   $\vartheta_3= 5.9087°$

$\Delta\alpha_{34} = 0°$

$\lambda_4= 1.562\mu m$   $\Lambda_4= 238.8348nm$   $\vartheta_4= 7.1066°$

Dieses Beispiel korrespondiert zu den Figuren 9 und 10. $\alpha_i = 0$ wird durch individuelle Kippung jedes der Gitterfelder realisiert.

Folgende Vorteile können mit der vorgeschlagenen erfindungsgemäßen Lösung realisiert werden:

- Äußerst präzise Definition der Differenz der charakteristischen Wellenlänge unterschiedlicher Wellenleiter.

- Eine im Gitter enthaltene Phasenverschiebung kann sich im einfachsten Fall über mehrere Wellenleiter erstrecken, da der Betrag der Phasenverschiebung unabhängig vom Kippwinkel ist (Figur 2, 4, 6 und 7).

- Eventuell reduzierter Endfacetten-Einfluß bzw. Einfluß der Endfacetten-Reflektion bei nicht vertikalem Verlauf der Wellenleiter bezüglich der Gittergrenzen oder Bauelementegrenzen.

- Möglichkeit einer sehr kostengünstigen, präzisen Definition des Abstandes der charakteristischen Wellenlänge von Wellenleiter zu Wellenleiter, wenn z. B. holographische Verfahren für die Gitterdefinition verwendet werden. Das gilt nicht nur für über ein großflächiges Gitterfeld verlaufende Wellenleiter (z. B. Figur 6), sondern auch für mehrere Gitterfelder (Figuren 9 bis 11). Diese Gitterfelder lassen sich hervorragend holographisch und damit auch kostengünstig realisieren. Die Gitterfelder werden z. B. nacheinander hergestellt und jeweils vor der Realisierung eines jeden Feldes i die Orientierung der zu begitternden Halbleiterschichtstruktur gemäß dem Winkel $\varphi_i$ zwischen einem Gitterstrich und der Vorzugsrichtung für den Wellenleiter i neu ausgerichtet und räumlich versetzt.

- Die Methode eignet sich besonders zur Erzeugung kleiner Wellenlängen-Unterschiede benachbarter Wellenleiter, welche sich gerade mit anderen Methoden besonders schwer herstellen lassen.

- Das Verfahren ist ungeachtet der speziellen Bauformen verschiedener photonischer Bauelemente anwendbar. (Diese Bauelemente müssen jedoch auf optischen Rückkopplungsgittern basieren.)

- Die Methode kann sowohl einen schrägen als auch einen senkrechten Verlauf der Wellenleiter zu den Vorzugsrichtungen realisieren. Der senkrechte Verlauf ist für die optische Ankopplung mehrerer Glasfasern bzw. eines Kopplerelements günstiger.

Aufstellung der verwendeten Bezugszeichen

| | |
|---|---|
| n | Anzahl der optischen Wellenleiter |
| i | Ordnungszahl der Wellenleiter |
| $\Lambda_o$ | Korrugationsperiode der Gitterbereiche außerhalb der Phasenverschiebungen (Phasensprünge) |
| $\vartheta_i$ | Winkel in der xy-Ebene zwischen einer Senkrechten zu einem Gitterstrich und der Richtung des Lichtwellenleiters i |
| $\alpha_i$ | Ein- oder Austrittswinkel des Lichtwellenleiters i |
| $\varphi_i$ | Winkel zwischen einem Gitterstrich und der Vorzugsrichtung für den Wellenleiter i |
| $\lambda_{B,i}$ | Braggwellenlänge des Wellenleiters i |
| $n_{eff,i}$ | effektiver Brechungsindex des Wellenleiters i |
| $d_i$ | laterale Breite des Wellenleiters i |
| $\lambda_i$ | spezifische Wellenlänge des Wellenleiters i |
| W | Gitterstegbreite |
| $W/k_o$ | Tastverhältnis |
| k | Anzahl der Phasenverschiebungen |

**Patentansprüche**

1. Optoelektronisches Multi-Wellenlängen Bauelement, das aus n optischen Wellenleitern besteht, deren optische Achsen in der xy-Ebene nebeneinander angeordnet sind, wobei jeder Wellenleiter in seinem Verlauf die gleiche Wellenleiterbreite oder eine lokale abschnittsweise Variation der Wellenleiterbreite aufweist, daß in jenen Bereichen der optischen Wellenleiter, in denen die Intensität der geführten Lichtfelder deutlich von Null verschieden ist, ein optisches Rückkopplungsgitter liegt, das entweder im Gitter keine Phasenverschiebung aufweist und durch eine konstante Korrugationsperiode gekennzeichnet ist, oder das eine oder mehrere Phasenverschiebungen aufweist und außerhalb der Phasenverschiebungen eine konstante Korrugationsperiode ausgebildet hat, wobei die in der xy-Ebene zwischen den Senkrechten zu den Gitterstrichen und der Richtung der Lichtwellenleiter angeordneten Winkel $\vartheta_i$ zwischen -50° und +50° liegen, auf dem Bauelement mindestens zwei optische Wellenleiter mit unterschiedlichen Winkeln $\vartheta_i$ angeordnet sind, wobei eine gezielte Änderung der effektiven Korrugationsperiode von Wellenleiter zu Wellenleiter, durch die für jeden Wellenleiter individuelle Bemessung des Winkels $\vartheta_i$ erfolgt, und dabei der für die erwünschte Braggwellenlänge des Wellenleiters $\lambda_{B,i}$ erforderliche Winkel $\vartheta_i$ für ein Gitter erster Ordnung für jeden Wellenleiter nach der Beziehung

$$\vartheta_i = \arccos\left(\frac{\Lambda_o \cdot 2 \cdot n_{eff,i}}{\lambda_{B,i}}\right)$$

ermittelt wird, wobei $\Lambda_o$ die Korrugationsperiode der Gitterbereiche außerhalb der Phasenverschiebungen und $n_{eff,i}$ der effektive Brechungsindex des Wellenleiters i ist, **dadurch gekennzeichnet, daß** die im optoelektronischen Bauelement angeordneten Gitterstriche des Rückkopplungsgitters gegenüber einer kristallographisch oder bauelemente-geometrisch ausgezeichneten Vorzugsrichtung, um den Winkel φ, φ > 0, zwischen einem Gitterstrich und der Vorzugsrichtung für den Wellenleiter i verkippt verlaufen.

2. Optoelektronisches Multi-Wellenlängen Bauelement nach Anspruch 1, **dadurch gekennzeichnet, daß** in den Wellenleiterrichtungen zusätzlich eine definierte Anzahl von gitterfreien Bereichen existieren und dadurch eine DBR-Struktur entsteht.

3. Optoelektronisches Multi-Wellenlängen Bauelement nach Anspruch 1, **dadurch gekennzeichnet, daß** in den Wellenleiterrichtungen zusätzlich eine definierte Anzahl von speziellen, gitterfreien Bereichen existieren und dadurch eine "sampled grating"-Struktur entsteht.

4. Optoelektronisches Multi-Wellenlängen Bauelement nach Anspruch 1, **dadurch gekennzeichnet, daß** zwischen 2 Ebenen, welche parallel zur xy-Ebene liegen, mehrere, gegenüber einer Vorzugsrichtung verschieden gekippte Gitterfelder liegen, wobei jedem Gitterfeld ein Wellenleiter zugeordnet ist.

5. Optoelektronisches Multi-Wellenlängen Bauelement nach Anspruch 1, **dadurch gekennzeichnet, daß** zwischen 2 Ebenen, welche parallel zur xy-Ebene liegen, mehrere, gegenüber einer Vorzugsrichtung verschieden gekippte Gitterfelder liegen, wobei jedem Gitterfeld mehrere Wellenleiter zugeordnet sind.

6. Optoelektronisches Multi-Wellenlängen Bauelement nach Anspruch 1, **dadurch gekennzeichnet, daß** einer der Wellenleiter die Gitterstriche senkrecht schneidet.

7. Optoelektronisches Multi-Wellenlängen Bauelement nach Anspruch 1, **dadurch gekennzeichnet, daß** keiner der Wellenleiter die Gitterstriche senkrecht schneidet.

8. Optoelektronisches Multi-Wellenlängen Bauelement nach Anspruch 1, **dadurch gekennzeichnet, daß** mehrere der Wellenleiter die Gitterstriche senkrecht schneiden.

9. Optoelektronisches Multi-Wellenlängen Bauelement nach Anspruch 1, **dadurch gekennzeichnet, daß** alle optischen Wellenleiter i unter jeweils verschiedenen Winkeln $\vartheta_i$ zu den Gitterstrichen verlaufen.

10. Optoelektronisches Multi-Wellenlängen Bauelement nach Anspruch 1, **dadurch gekennzeichnet, daß** mehrere der n optischen Wellenleiter unter demselben Winkel $\vartheta_i$ angeordnet sind.

11. Optoelektronisches Multi-Wellenlängen Bauelement nach Anspruch 1, **dadurch gekennzeichnet, daß** der Winkel $\vartheta_i$ in einer Wellenleitersequenz i = 1, 2, 3, ... n zunimmt.

12. Optoelektronisches Multi-Wellenlängen Bauelement nach Anspruch 1, **dadurch gekennzeichnet, daß** der Winkel $\vartheta_i$ in einer Wellenleitersequenz i = 1, 2, 3, ... n abnimmt.

**13.** Optoelektronisches Multi-Wellenlängen Bauelement nach Anspruch 1, **dadurch gekennzeichnet, daß** die Zuordnung der Winkel $\vartheta_i$ zu den einzelnen Wellenleitern beliebig ist.

**14.** Optoelektronisches Multi-Wellenlängen Bauelement nach Anspruch 1, **dadurch gekennzeichnet, daß** die Gitterstriche jedes einzelnen Gitterfeldes i, welches zu einem Wellenleiter i korrespondiert, um einen individuellen Winkel $\varphi_i$ gegenüber einer Vorzugsrichtung verkippt sind.

**15.** Optoelektronisches Multi-Wellenlängen Bauelement nach Anspruch 1, **dadurch gekennzeichnet, daß** die Gitterstriche jedes einzelnen Gitterfeldes i, welches zu einem Wellenleiter i korrespondiert um einen individuellen Winkel $\varphi_i$ gegenüber einer Vorzugsrichtung verkippt sind, wobei die Wellenleiter senkrecht zu den Spaltflächen definiert sind.

**16.** Optoelektronisches Multi-Wellenlängen Bauelement nach Anspruch 1, **dadurch gekennzeichnet, daß** die Gitterstriche jedes einzelnen Gitterfeldes i, welches zu einem Wellenleiter i korrespondiert um einen individuellen Winkel $\varphi_i$ gegenüber einer Vorzugsrichtung verkippt sind, wobei der Ein- oder Austrittswinkel des Lichtwellenleiters $\alpha_i$, der Winkel $\vartheta_i$ und der Winkel zwischen einem Gitterstrich und der Vorzugsrichtung $\varphi_i$ völlig unabhängig voneinander sind.

**17.** Optoelektronisches Multi-Wellenlängen Bauelement nach Anspruch 1, **dadurch gekennzeichnet, daß** die Phasenverschiebung in den Gittern hergestellt ist, so daß innerhalb eines Wellenleiters eine Phasenverschiebung ausgebildet ist.

**18.** Optoelektronisches Multi-Wellenlängen Bauelement nach Anspruch 1, **dadurch gekennzeichnet, daß** die Phasenverschiebung innerhalb des Gitters existiert, wobei der Gesamtphasenverschiebungsbetrag innerhalb eines Wellenleiters auf mehrere in Wellenleiterrichtung versetzte einzelne Phasenverschiebungen im Gitter aufgeteilt ist.

**19.** Optoelektronisches Multi-Wellenlängen Bauelement nach Anspruch 1, **dadurch gekennzeichnet, daß** pro Wellenleiter eine Phasenverschiebung durch eine gezielte, lokale, abschnittsweise Veränderung der Wellenleiterbreite realisiert ist.

**20.** Optoelektronisches Multi-Wellenlängen Bauelement nach Anspruch 1, **dadurch gekennzeichnet, daß** der Gesamtphasenverschiebungsbetrag innerhalb eines Wellenleiters auf mehrere in Ausbreitungsrichtung des Lichtes versetzte, einzelne Phasenverschiebungen aufgeteilt ist, wobei diese einzelnen Phasenverschiebungen durch jeweilige lokale, abschnittsweise Änderung der Wellenleiterbreite realisiert sind.

**21.** Optoelektronische Multi-Wellenlängen Bauelement nach Anspruch 1, **dadurch gekennzeichnet, daß** die Wellenleiter i unterschiedliche Grundbreiten $d_i$ aufweisen.

**22.** Optoelektronisches Multi-Wellenlängen Bauelement nach Anspruch 1, **dadurch gekennzeichnet, daß** Kombinationen von Wellenleiterverengungen und Verbreiterungen innerhalb eines Wellenleiters ausgebildet sind.

**23.** Optoelektronisches Multi-Wellenlängen Bauelement nach Anspruch 1, **dadurch gekennzeichnet, daß** die Kopplung des Gitters komplex ist und Brechungsindex- sowie Gewinnkopplung beinhaltet.

**24.** Optoelektronisches Multi-Wellenlängen Bauelement nach Anspruch 1, **dadurch gekennzeichnet, daß** die Kopplung des Gitters komplex ist und Brechungsindex- sowie Verlustkopplung beinhaltet.

**25.** Optoelektronisches Multi-Wellenlängen Bauelement nach Anspruch 1, **dadurch gekennzeichnet, daß** die Kopplung des Gitters rein imaginär ist und Gewinnkopplung beinhaltet.

**26.** Optoelektronisches Multi-Wellenlängen Bauelement nach Anspruch 1, **dadurch gekennzeichnet, daß** die Kopplung des Gitters rein imaginär ist und Verlustkopplung beinhaltet.

**27.** Optoelektronisches Multi-Wellenlängen Bauelement nach Anspruch 1, **dadurch gekennzeichnet, daß** die Kopplung des Gitters reell ist und reine Indexkopplung beinhaltet.

**28.** Optoelektronisches Multi-Wellenlängen Bauelement nach Anspruch 1, **dadurch gekennzeichnet, daß** die Wellenleiter beliebig gekrümmt ausgebildet sind.

29. Optoelektronisches Multi-Wellenlängen Bauelement nach Anspruch 1, **dadurch gekennzeichnet, daß** der Phasenverschiebungsbetrag innerhalb jedes einzelnen Wellenleiters durch jeweils eine gezielte, individuelle Wellenleiterkrümmungsfunktion definiert ist.

30. Optoelektronisches Multi-Wellenlängen Bauelement nach Anspruch 1, **dadurch gekennzeichnet, daß** jeder Wellenleiter aus einer beliebigen Kombination gerader und individuell gekrümmter Teilstrecken besteht.

31. Optoelektronisches Multi-Wellenlängen Bauelement nach Anspruch 1, **dadurch gekennzeichnet, daß** der Gesamtphasenverschiebungsbetrag jedes Wellenleiters durch eine Kombination von lokaler Wellenleiterbreite-Variation, Phasenverschiebungen im Gitter sowie einer Wellenleiterkrümmung definiert ist.

32. Optoelektronisches Multi-Wellenlängen Bauelement nach Anspruch 1, **dadurch gekennzeichnet, daß** die Winkel $\vartheta_i$ und die Ein- oder Austrittswinkel des Lichtwellenleiters $\alpha_i$ betragsmäßig kleiner als 50° sind.

**Claims**

1. Optoelectronic multi-wavelength component consisting of n optical waveguides, the optical axes of said waveguides being adjacent in the xy-plane, each waveguide having over its extent the same waveguide width or a local portionwise variation of the waveguide width, wherein, in those regions of the optical waveguides in which the intensity of the conducted light fields is significantly different from zero, there is an optical feedback grating which either has no phase shift in the grating or is **characterized by** a constant corrugation period, or which has one or more phase shifts and has a constant corrugation period outside of the phase shifts, wherein the angles $\vartheta_i$ in the xy-plane between the perpendiculars to the grating lines and the direction of the optical waveguides are between -50° and +50°, the component having at least two optical waveguides with different angles $\vartheta_i$, a selective change of the effective corrugation period from waveguide to waveguide being accomplished through the waveguide-specific dimensioning of angle $\vartheta_i$, wherein the angle $\vartheta_i$ required for the desired Bragg wavelength of waveguide $\lambda_{B,i}$ is calculated for a grating of the first order for each waveguide according to the relation

$$\vartheta_i = \arccos\left(\frac{\Lambda_o \cdot 2 \cdot n_{eff,i}}{\lambda_{B,i}}\right),$$

where $\Lambda_o$ is the corrugation period of the grating regions outside of the phase shifts and $n_{eff,i}$ is the effective refractive index of waveguide i, **characterized in that** the grating lines of the feedback grating disposed in the optoelectronic component are tilted in relation to a crystallographically or component-geometrically distinguished privileged direction by the angle $\varphi$, $\varphi > 0$, between a grating line and the privileged direction for waveguide i.

2. Optoelectronic multi-wavelength component according to claim 1, **characterized in that** in the waveguide directions there additionally exist a defined number of grating-free regions, this giving rise to a DBR structure.

3. Optoelectronic multi-wavelength component according to claim 1, **characterized in that** in the waveguide directions there additionally exist a defined number of special, grating-free regions, this giving rise to a sampled grating structure.

4. Optoelectronic multi-wavelength component according to claim 1, **characterized in that** situated between 2 planes parallel to the xy-plane are a plurality of grating fields variously tilted in relation to a privileged direction, each grating field being associated with one waveguide.

5. Optoelectronic multi-wavelength component according to claim 1, **characterized in that** situated between 2 planes parallel to the xy-plane are a plurality of grating fields variously tilted in relation to a privileged direction, each grating field being associated with a plurality of waveguides.

6. Optoelectronic multi-wavelength component according to claim 1, **characterized in that** one of the waveguides perpendicularly intersects the grating lines.

7. Optoelectronic multi-wavelength component according to claim 1, **characterized in that** none of the waveguides perpendicularly intersects the grating lines.

8. Optoelectronic multi-wavelength component according to claim 1, **characterized in that** a plurality of the waveguides perpendicularly intersect the grating lines.

9. Optoelectronic multi-wavelength component according to claim 1, **characterized in that** all optical waveguides i each extend at different angles $\vartheta_i$ to the grating lines.

10. Optoelectronic multi-wavelength component according to claim 1, **characterized in that** a plurality of the n optical waveguides are disposed at the same angle $\vartheta_i$.

11. Optoelectronic multi-wavelength component according to claim 1, **characterized in that** the angle $\vartheta_i$ increases in a waveguide sequence i = 1, 2, 3, ... n.

12. Optoelectronic multi-wavelength component according to claim 1, **characterized in that** the angle $\vartheta_i$ decreases in a waveguide sequence i = 1, 2, 3, ... n.

13. Optoelectronic multi-wavelength component according to claim 1, **characterized in that** the association of the angles $\vartheta_i$ with the individual waveguides is random.

14. Optoelectronic multi-wavelength component according to claim 1, **characterized in that** the grating lines of each individual grating field i corresponding to a waveguide i are tilted by an individual angle $\varphi_i$ in relation to a privileged direction.

15. Optoelectronic multi-wavelength component according to claim 1, **characterized in that** the grating lines of each individual grating field i corresponding to a waveguide i are tilted by an individual angle $\varphi_i$ in relation to a privileged direction, the waveguides being defined perpendicularly to the cleavage faces.

16. Optoelectronic multi-wavelength component according to claim 1, **characterized in that** the grating lines of each individual grating field i corresponding to a waveguide i are tilted by an individual angle $\varphi_i$ in relation to a privileged direction, the entry or exit angle of waveguide $\alpha_i$, the angle $\vartheta_i$ and the angle between a grating line and the privileged direction $\varphi_i$ being completely independent of each other.

17. Optoelectronic multi-wavelength component according to claim 1, **characterized in that** the phase shift is produced in the gratings, with the result that a phase shift is formed within a waveguide.

18. Optoelectronic multi-wavelength component according to claim 1, **characterized in that** the phase shift exists within the grating, the total phase shift value within a waveguide being divided between a plurality of individual phase shifts in the grating, said individual phase shifts being offset in the direction of the waveguide.

19. Optoelectronic multi-wavelength component according to claim 1, **characterized in that**, for each waveguide, a phase shift is realized through a selective, local, portionwise variation of the waveguide width.

20. Optoelectronic multi-wavelength component according to claim 1, **characterized in that** the total phase shift value within a waveguide is divided between a plurality of individual phase shifts, said individual phase shifts being offset in the propagation direction of the light, said individual phase shifts being realized through respective local, portionwise changing of the waveguide width.

21. Optoelectronic multi-wavelength component according to claim 1, **characterized in that** the waveguides i have different base widths $d_i$.

22. Optoelectronic multi-wavelength component according to claim 1, **characterized in that** combinations of waveguide narrowings and widenings are formed within a waveguide.

23. Optoelectronic multi-wavelength component according to claim 1, **characterized in that** the coupling of the grating is complex and includes refractive index and gain coupling.

24. Optoelectronic multi-wavelength component according to claim 1, **characterized in that** the coupling of the grating is complex and includes refractive index and loss coupling.

**25.** Optoelectronic multi-wavelength component according to claim 1, **characterized in that** the coupling of the grating is purely imaginary and includes gain coupling.

**26.** Optoelectronic multi-wavelength component according to claim 1, **characterized in that** the coupling of the grating is purely imaginary and includes loss coupling.

**27.** Optoelectronic multi-wavelength component according to claim 1, **characterized in that** the coupling of the grating is real and includes pure index coupling.

**28.** Optoelectronic multi-wavelength component according to claim 1, **characterized in that** the waveguides are randomly curved in form.

**29.** Optoelectronic multi-wavelength component according to claim 1, **characterized in that** the phase shift value within each individual waveguide is defined by a selective, individual waveguide curvature function.

**30.** Optoelectronic multi-wavelength component according to claim 1, **characterized in that** each waveguide consists of a random combination of straight and individually curved sections.

**31.** Optoelectronic multi-wavelength component according to claim 1, **characterized in that** the total phase shift value of each waveguide is defined by a combination of local waveguide width variation, phase shifts in the grating and waveguide curvature.

**32.** Optoelectronic multi-wavelength component according to claim 1, **characterized in that** the angles $\vartheta_i$ and the entry or exit angles of the optical waveguide $\alpha_i$ are smaller in value than 50°.

**Revendications**

**1.** Composant optoélectronique à longueurs d'onde multiples, composé de n guides d'ondes optiques, dont les axes optiques sont disposés l'un à côté de l'autre sur le plan xy, chaque guide d'ondes ayant sur toute sa longueur la même largeur ou présentant une variation locale de sa largeur par segment, tel que, dans les parties des guides d'ondes optiques dans lesquelles l'intensité des champs lumineux diffusés s'écarte nettement de zéro, se trouve une grille optique de rétroaction, laquelle soit ne présente pas de décalage de phase et est **caractérisée par** une période constante de corrugation, soit présente un ou plusieurs décalages de phase et a généré une période constante de corrugation en dehors des décalages de phase, les angles $\vartheta_i$ entre les perpendiculaires aux lignes de la grille et la direction des guides d'ondes lumineuses sur le plan xy étant compris entre - 50° et + 50°, au moins deux guides d'ondes optiques à angles $\vartheta_i$ différents étant placés sur le composant, la période effective de corrugation de guide d'ondes à guide d'ondes étant modifiée de manière ciblée par la mesure individuelle de l'angle $\vartheta_i$ pour chaque guide d'ondes et l'angle $\vartheta_i$ nécessaire pour la longueur d'onde de Bragg du guide d'ondes $\lambda_{B,i}$ pour une grille de premier ordre étant calculé pour chaque guide d'ondes selon la formule

$$\vartheta_i = \text{arc cos} \left( \frac{\Lambda_o \cdot 2 \cdot n_{eff,i}}{\lambda_{B,i}} \right),$$

$\Lambda_o$ étant la période de corrugation des parties de la grille en dehors des décalages de phase et $n_{eff,i}$ étant l'indice de réfraction effectif du guide d'ondes i,
**caractérisé en ce que** les lignes de la grille de rétroaction placées dans le composant optoélectronique sont inclinées par rapport à une direction préférentielle définie selon des critères cristallographiques ou ayant trait à la géométrie du composant, de l'angle φ, φ > 0, entre une ligne de la grille et la direction préférentielle du guide d'ondes i.

**2.** Composant optoélectronique à longueurs d'onde multiples selon la revendication 1, **caractérisé en ce qu'**il existe en plus dans les directions des guides d'ondes un nombre défini de domaines hors grille, de sorte qu'il en résulte une structure DBR.

**3.** Composant optoélectronique à longueurs d'onde multiples selon la revendication 1, **caractérisé en ce qu'**il existe en plus dans les directions des guides d'ondes un nombre défini de domaines hors grille spéciaux, de sorte qu'il en résulte une structure de « sampled grating ».

4. Composant optoélectronique à longueurs d'onde multiples selon la revendication 1, **caractérisé en ce qu'**il existe, entre deux plans parallèles au plan xy, plusieurs champs de grille différemment inclinés par rapport à une direction préférentielle, un guide d'ondes étant affecté à chaque champ de grille.

5. Composant optoélectronique à longueurs d'onde multiples selon la revendication 1, **caractérisé en ce qu'**il existe, entre deux plans parallèles au plan xy, plusieurs champs de grille différemment inclinés par rapport à une direction préférentielle, plusieurs guides d'ondes étant affectés à chaque champ de grille.

6. Composant optoélectronique à longueurs d'onde multiples selon la revendication 1, **caractérisé en ce que** l'un des guides d'ondes coupe perpendiculairement les lignes de la grille.

7. Composant optoélectronique à longueurs d'onde multiples selon la revendication 1, **caractérisé en ce qu'**aucun des guides d'ondes ne coupe perpendiculairement les lignes de la grille

8. Composant optoélectronique à longueurs d'onde multiples selon la revendication 1, **caractérisé en ce que** plusieurs guides d'ondes coupent perpendiculairement les lignes de la grille.

9. Composant optoélectronique à longueurs d'onde multiples selon la revendication 1, **caractérisé en ce que** tous les guides d'ondes optiques i forment des angles $\vartheta_i$ différents avec les lignes de la grille.

10. Composant optoélectronique à longueurs d'onde multiples selon la revendication 1, **caractérisé en ce que** plusieurs des n guides d'ondes optiques sont disposés selon le même angle $\vartheta_i$.

11. Composant optoélectronique à longueurs d'onde multiples selon la revendication 1, **caractérisé en ce que** l'angle $\vartheta_i$ augmente dans une séquence de guides d'ondes i = 1, 2, 3,...n.

12. Composant optoélectronique à longueurs d'onde multiples selon la revendication 1, **caractérisé en ce que** l'angle $\vartheta_i$ diminue dans une séquence de guides d'ondes i = 1, 2, 3,... n.

13. Composant optoélectronique à longueurs d'onde multiples selon la revendication 1, **caractérisé en ce que** l'affectation des angles $\vartheta_i$ aux différents guides d'ondes est indifférente.

14. Composant optoélectronique à longueurs d'onde multiples selon la revendication 1, **caractérisé en ce que** les lignes de chaque champ de grille i correspondant à un guide d'ondes i sont inclinées d'un angle individuel $\varphi_i$ par rapport à une direction préférentielle.

15. Composant optoélectronique à longueurs d'onde multiples selon la revendication 1, **caractérisé en ce que** les lignes de chaque champ de grille i correspondant à un guide d'ondes i sont inclinées d'un angle individuel $\varphi_i$ par rapport à une direction préférentielle, les guides d'ondes étant définis comme perpendiculaires par rapport aux facettes de clivage.

16. Composant optoélectronique à longueurs d'onde multiples selon la revendication 1, **caractérisé en ce que** les lignes de chaque champ de grille i correspondant à un guide d'ondes i sont inclinées d'un angle individuel $\varphi_i$ par rapport à une direction préférentielle, l'angle d'entrée ou de sortie $\alpha_i$, l'angle $\vartheta_i$ et l'angle $\varphi_i$ entre une ligne de la grille et la direction préférentielle étant totalement indépendants les uns des autres.

17. Composant optoélectronique à longueurs d'onde multiples selon la revendication 1, **caractérisé en ce que** le décalage de phase est généré dans les grilles, de sorte qu'un décalage de phase a lieu à l'intérieur d'un guide d'ondes.

18. Composant optoélectronique à longueurs d'onde multiples selon la revendication 1, **caractérisé en ce qu'**il y a décalage de phase à l'intérieur de la grille, le décalage de phase total à l'intérieur d'un guide d'ondes étant subdivisé dans la grille en plusieurs décalages de phase répartis sur la longueur du guide d'ondes.

19. Composant optoélectronique à longueurs d'onde multiples selon la revendication 1, **caractérisé en ce que**, pour chaque guide d'ondes, un décalage de phase est réalisé par une modification ciblée, locale et par segment de la largeur du guide d'ondes.

**20.** Composant optoélectronique à longueurs d'onde multiples selon la revendication 1, **caractérisé en ce que** le décalage de phase total à l'intérieur d'un guide d'ondes est subdivisé en plusieurs décalages de phase répartis sur la direction de diffusion de la lumière, ces différents décalages de phase étant réalisés par des modifications locales par segment de la largeur du guide d'ondes.

**21.** Composant optoélectronique à longueurs d'onde multiples selon la revendication 1, **caractérisé en ce que** les guides d'ondes i ont différentes largeurs de base $d_i$.

**22.** Composant optoélectronique à longueurs d'onde multiples selon la revendication 1, **caractérisé en ce qu'**il existe, à l'intérieur d'un guide d'ondes, des combinaisons de rétrécissements et d'élargissements du guide d'ondes.

**23.** Composant optoélectronique à longueurs d'onde multiples selon la revendication 1, **caractérisé en ce que** la jonction sur la grille est complexe et comprend aussi bien une jonction au niveau de l'indice de réfraction qu'au niveau du gain.

**24.** Composant optoélectronique à longueurs d'onde multiples selon la revendication 1, **caractérisé en ce que** la jonction sur la grille est complexe et comprend aussi bien une jonction au niveau de l'indice de réfraction qu'au niveau de la perte.

**25.** Composant optoélectronique à longueurs d'onde multiples selon la revendication 1, **caractérisé en ce que** la jonction sur la grille est purement imaginaire et comprend une jonction au niveau du gain.

**26.** Composant optoélectronique à longueurs d'onde multiples selon la revendication 1, **caractérisé en ce que** la jonction sur la grille est purement imaginaire et comprend une jonction au niveau de la perte.

**27.** Composant optoélectronique à longueurs d'onde multiples selon la revendication 1, **caractérisé en ce que** la jonction sur la grille est réelle et purement au niveau de l'indice.

**28.** Composant optoélectronique à longueurs d'onde multiples selon la revendication 1, **caractérisé en ce que** les guides d'ondes sont plus ou moins courbés.

**29.** Composant optoélectronique à longueurs d'onde multiples selon la revendication 1, **caractérisé en ce que** le décalage de phase total à l'intérieur de chaque guide d'ondes est défini par une fonction de courbure du guide d'ondes individuellement ciblée.

**30.** Composant optoélectronique à longueurs d'onde multiples selon la revendication 1, **caractérisé en ce que** chaque guide d'ondes est constitué d'une combinaison quelconque de tronçons droits et individuellement courbés.

**31.** Composant optoélectronique à longueurs d'onde multiples selon la revendication 1, **caractérisé en ce que** le décalage de phase total à l'intérieur de chaque guide d'ondes est défini par une combinaison de variation locale de la largeur du guide d'ondes, de décalages de phase dans la grille et d'une courbure du guide d'ondes.

**32.** Composant optoélectronique à longueurs d'onde multiples selon la revendication 1, **caractérisé en ce que** les angles $\vartheta_i$ et les angles $\alpha_i$ d'entrée ou de sortie du guide d'ondes sont inférieurs à 50°.

Fig. 1

Fig.2

Fig.3

Fig. 4

Fig. 5

Fig.6

Fig.7

Fig.8

$\vartheta_4$

$\alpha_4 = 0$

$\varphi_4 = \vartheta_4$

$\vartheta_3$

$\alpha_3 = 0$

$\varphi_3 = \vartheta_3$

$\vartheta_2$

$\alpha_2 = 0$

$\varphi_2 = \vartheta_2$

$\vartheta_1 = 0$

$\alpha_1 = 0$

$\varphi_1 = \vartheta_1$

Fig. 9

Fig.10

$\alpha_4 = 0$

$\vartheta_4$

$\varphi_4 = \vartheta_4$

$\vartheta_3$

$\alpha_3 = 0$

$\varphi_3 = \vartheta_3$

$\vartheta_2$

$\alpha_2 = 0$

$\varphi_2 = \vartheta_2$

$\vartheta_1 = 0$
$\alpha_1 = 0$

$\varphi_1 = \vartheta_1$

Fig.11

Fig.12

Fig.13

Fig.14